# EUROPÄISCHE PATENTSCHRIFT

(11) **EP 1 382 062 B1**
(45) Veröffentlichungstag und Bekanntmachung des Hinweises auf die Patenterteilung: **14.11.2007**
(21) Anmeldenummer: 02766602.3
(22) Anmeldetag: 10.04.2002
(51) Int. Cl.: H01L 21/28, H01L 21/321

(54) **VERFAHREN ZUR MINIMIERUNG DER WOLFRAMOXIDABSCHEIDUNG BEI DER SELEKTIVEN SEITENWANDOXIDATION VON WOLFRAM-SILIZIUM-GATES**
METHOD FOR MINIMIZING TUNGSTEN OXIDE FORMATION DURING SELECTIVE SIDEWALL OXIDATION OF TUNGSTEN-SILICON GATES
PROCEDE SERVANT A MINIMISER LA FORMATION DE L'OXYDE DE TUNGSTENE AU COURS DE L'OXYDATION SELECTIVE DE PAROI LATERALE DE PORTES TUNGSTENE-SILICIUM

(30) Priorität: 26.04.2001 DE 10120523
(43) Veröffentlichungstag der Anmeldung: 21.01.2004
(73) Patentinhaber: Infineon Technologies AG, 81669 München (DE); Mattson Thermal Products GmbH, 89160 Dornstadt (DE)
(72) Erfinder: FRIGGE, Steffen, 09131 Chemnitz (DE); KEGEL, Wilhelm, 01465 Langebrück (DE); SACHSE, Jens-Uwe, 01217 Dresden (DE); STADTMÜLLER, Michael, 01109 Dresden (DE); HAYN, Regina, F-77300 Fontainebleau (FR); ROTERS, Georg, 48249 Dülmen (DE); SCHOER, Erwin, 01099 Dresden (DE); STORBECK, Olaf, 01099 Dresden (DE)
(74) Vertreter: Graf Lambsdorff, Matthias
(86) Internationale Anmeldenummer: PCT/DE2002/001321
(87) Internationale Veröffentlichungsnummer: WO 2002/089190

(56) Entgegenhaltungen:
- US-A- 6 162 741
- PATENT ABSTRACTS OF JAPAN vol. 1999, no. 05, 31. Mai 1999 (1999-05-31) -& JP 11 031666 A (TOSHIBA CORP), 2. Februar 1999 (1999-02-02) -& US 6 228 752 B1 (MIYANO KIYOTAKA) 8. Mai 2001 (2001-05-08)

## Beschreibung

Die Erfindung betrifft generell das Gebiet der Herstellung von Metallisierungsstrukturen, insbesondere Gatestrukturen, in welchen mindestens eine Schicht aus polykristallinem Silizium und mindestens eine Wolframschicht enthalten ist. Insbesondere bezieht sich die Erfindung auf ein selektives Oxidationsverfahren einer derartigen Metallisierungsstruktur gemäß dem Oberbegriff des Patentanspruchs 1.

Im Zuge der fortschreitenden Verkleinerung von MOS-Transistoren wird in zunehmendem Maße Wolfram als ein Bestandteil des Gate-Aufbaus eingesetzt. Wolfram hat als Gate-Material gegenüber dem ebenfalls bereits vielfach verwendeten Wolframsilizid wesentliche Vorteile. Der geringere spezifische Widerstand von Wolfram gegenüber Wolframsilizid ermöglicht eine Reduzierung des Widerstandes des Gates und somit verbesserte elektrische Eigenschaften der Transistoren. Aufgrund des geringeren spezifischen Widerstands kann auch die Höhe des schichtförmigen Gateaufbaus deutlich verringert werden, wodurch die verschiedenen Füll- und Ätzschritte wesentlich vereinfacht werden, da dass Aspektverhältnis (Verhältnis von Höhe zum Abstand benachbarter Gates) geringer wird.

Bei der Herstellung des mehrschichtigen Gateaufbaus werden zunächst üblicherweise auf einem Siliziumsubstrat eine Gateoxidschicht, eine polykristalline Siliziumschicht, eine Wolframnitridschicht, eine Wolframschicht und eine Siliziumnitridschicht aufgebracht. Durch Photolithographie und vertikale Ätzung werden dann einzelne Gatebereiche definiert, die jeweils oberhalb eines Kanals eines MOS-Transistors zu liegen kommen sollen. Um die geätzten Seitenwände der Gateaufbauten ("stacks") elektrisch zu isolieren und um Ätzschäden auszuheilen, müssen auf die Seitenwände geeignete Isolationsschichten aufgebracht werden. Für die polykristalline Siliziumschicht eignet sich hierfür am besten eine SiO₂-Schicht, die durch eine thermische Oxidation erzeugt wird. Gleichzeitig muss jedoch eine Oxidation der Wolframschicht verhindert werden, da diese sich erfahrungsgemäß nicht auf die Oberfläche beschränkt, sondern sich in lateraler Richtung in der Schicht fortsetzt und somit hochohmiges Wolframoxid erzeugt, wodurch die elektrische Funktionalität des Gates verhindert wird.

Es sind verschiedene Verfahren zur Seitenwanderzeugung einer eine Wolframschicht enthaltenden Gateelektrode bekannt geworden.

In der US-A-6,165,883 wird ein Verfahren beschrieben, welches auf einer selektiven Oxidation des Gateaufbaus beruht. Dieses Verfahren wird nachfolgend anhand der Zeichnungsfiguren 1A bis 1C näher erläutert.

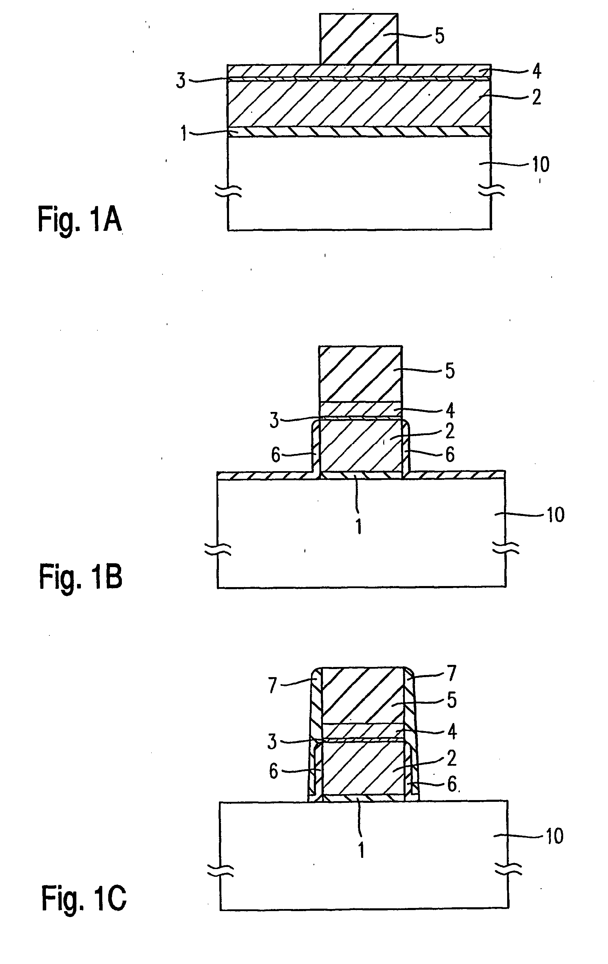

Auf einem Siliziumsubstrat 10 wird durch thermische Oxidation eine Gateoxidschicht 1 gebildet und nachfolgend auf dieser eine polykristalline Siliziumschicht 2, eine Barriereschicht 3 aus Wolframnitrid oder Titannitrid, eine Wolframschicht 4 und eine Siliziumnitridschicht 5 abgeschieden. Zur Definition der Gatebereiche wird anschließend die Siliziumnitridschicht 5 strukturiert, so dass für einen Gatebereich die Struktur der Fig. 1A erhalten wird. Die mesaförmig geätzte Struktur 5 der Siliziumnitridschicht dient im folgenden als Ätzmaske. Dann werden in einem vertikalen Ätzschritt die Schichten 1 bis 4 in den Bereichen zwischen den Gatestrukturen entfernt, so dass von dem Schichtaufbau nur noch einzelne definierte Gatebereiche stehen bleiben. Anschließend wird eine selektive Oxidation in einer Wasser und Wasserstoff enthaltenden Atmosphäre bei 800°C durchgeführt, bei der nur auf dem Siliziumsubstrat 10 und an den Seitenwänden der polykristallinen Siliziumschicht 2 Siliziumoxidschichten 6 gebildet werden. Die Wolframschicht 4 wird dagegen nicht oxidiert. Die somit erhaltene Struktur ist in der Fig. 1B dargestellt. Schließlich wird noch eine Siliziumnitridschicht 7 als Isolationsschicht auf die Seitenwände der Siliziumnitridschicht 5, der Wolframschicht 4, der Wolframnitridschicht 3 und die Siliziumoxidschicht 6 aufgebracht. Somit ist die Gatestruktur nunmehr an allen Seiten von elektrisch isolierenden Seitenwänden umgeben. Der Einfachheit halber sollen die sich daran anschlie-ßenden Prozessschritte, die in der erwähnten Druckschrift erläutert sind, hier nicht weiter betrachtet werden.

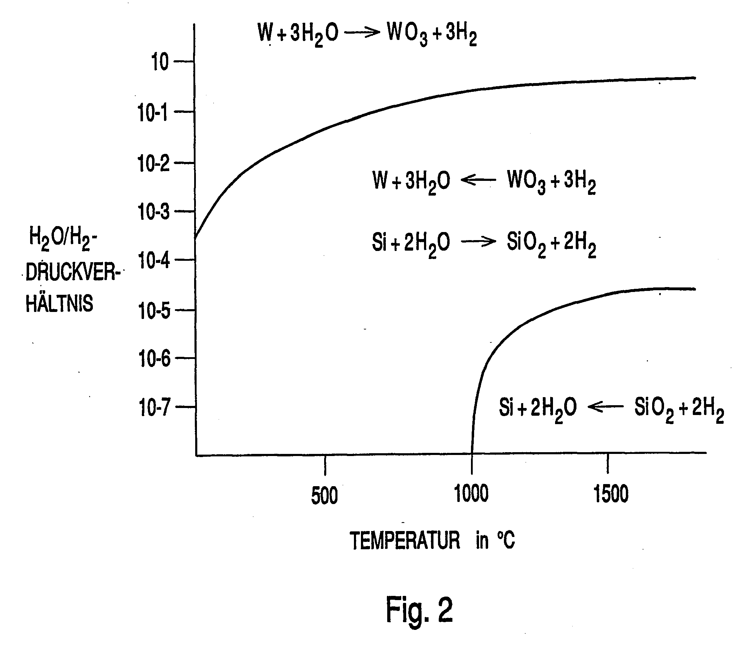

Für die Durchführung der selektiven Oxidation kommt es darauf an, in der Reaktionskammer ein bestimmtes Mischungsverhältnis des Wasserstoff-/Wasser-Gemisches einzustellen. In der Fig. 2 ist das an den Durchflussreglern der Reaktionskammer eingestellte Druckverhältnis H₂O/H₂, somit also das sich in der Reaktionskammer einstellende entsprechende Konzentrationsverhältnis gegenüber der Prozesstemperatur aufgetragen. Eingezeichnet sind Reaktionsgleichgewiqhtskurven, auf denen bestimmte Oxidationsreaktionen mit den zugehörigen Reduktionsreaktionen im Gleichgewicht stehen. Bezüglich der Oxidation bzw. Reduktion von Wolfram ist die obere Gleichgewichtskurve maßgebend, während für die Oxidation bzw. Reduktion von Silizium die untere Gleichgewichtskurve kennzeichnend ist. In beiden Fällen führt ausgehend von der jeweiligen Gleichgewichtskurve ein Anstieg des Wasserdampfanteils und/oder ein Rückgang in der Prozesstemperatur zu einem Ungleichgewicht zugunsten der betreffenden Oxidationsreaktion. Es kommt darauf an, die Prozeßbedingungen Wafertemperatur und Mischungsverhältnis so einzustellen, daß der Arbeitspunkt in dem Diagramm der Fig.2 im mittleren Bereich zwischen den dargestellten Gleichgewichtskurven liegt.

Bei der selektiven Oxidation, die gemäß Fig. 1B mit dem Ziel der Bildung der Siliziumoxidschichten 6 durch eine Nassoxidation in wasserstoffreicher Atmosphäre durchgeführt wird, kommt es jedoch bisher noch in zu starkem Maße zur Bildung von Wolframoxid in der den Gatebereich umgebenden Atmosphäre.

Dieses Wolframoxid ist bei den Prozesstemperaturen flüchtig und lagert sich an den Wänden der Prozesskammer an, wo es durch den Wasserstoff zu metallischem Wolfram reduziert wird. Da sich diese Wolfram-Ablagerungen bei lampenbeheizten RTP-(Rapid Thermal Processing) Anlagen, die vorzugsweise für die selektive Oxidation verwendet werden, damit auf den Quarzteilen zwischen den Lampen und dem Wafer befinden und aufgrund ihrer optischen Eigenschaften die Lampenstrahlung teilweise absorbieren, haben sie einen sehr großen Einfluss auf die Temperaturhomogenität des Wafers und verschlechtern diese drastisch. Zusätzlich können sich Wolfram-Ablagerungen auch auf den Quarzteilen vor den Pyrometern bilden und damit die optische Messung der Wafertemperatur negativ beeinträchtigen. Bei einer Prozessierung unter Produktionsbedingungen, d.h. wiederholte Prozessierung des selben Prozesses auf vielen Produktionsscheiben, führt die zunehmende Wolfram-Ablagerung zu einer so schnellen Degradation der Schichtdicken-Homogenität über dem Wafer sowie von Wafer zu Wafer, dass der Prozess für produktive Anwendungen derzeit nicht stabil genug ist.

Der durch das Abdampfen von Wolframoxid hervorgerufene Verlust an Wolfram kann überdies zu einer Schädigung der elektrischen Funktionalität der Leitbahnen führen. Weiterhin kann die Wiederabscheidung von Wolframoxid, gefolgt von einer Reduzierung zu Wolfram, zur Bildung von unerwünschten leitenden Verbindungen und damit zum Kurzschluß von Bauelementen auf der Scheibe führen. Diese Probleme sind nicht auf lampengeheizte RTP-Anlagen beschränkt, sondern treten bei allen Temperanlagen auf, die für selektive Oxidation genutzt werden können, wie z.B. auch konventionelle Öfen. Bei letzteren stellt indes die Ablagerung von Wolframoxid auf den Kammerwänden und die nachfolgende Reduzierung zu Wolfram kein so gravierendes Problem dar.

In der Druckschrift US-A-6,162,741 wird ein Verfahren zur selektiven Oxidation einer eine Wolframschicht und eine Polysiliziumschicht enthaltenden Gate-Struktur beschrieben. Die Gate-Struktur wird in einem Behandlungsschritt mit einem Gemisch aus Wasserstoff und Wasser behandelt (Schritt 7 in Fig. 5). Vor diesem Behandlungsschritt wird die Gate-Struktur mit einem Gemisch aus Wasserstoff und Stickstoff behandelt (Schritt 4 in Fig. 5). Mit diesem letztgenannten Schritt kann die Ausdampfung von Wolfram-Oxid bereits in nennenswertem Umfang verringert werden.

Es ist dementsprechend Aufgabe der vorliegenden Erfindung, ein Verfahren zur selektiven Oxidation einer Metallisierungsstruktur, insbesondere einer Gatestruktur, welche mindestens eine zu oxidierende Siliziumschicht und mindestens eine nicht zu oxidierende Wolframschicht enthält, anzugeben, bei welchem die Ausdampfungen von Wolframoxid aus der die Metallisierungsstruktur umgebenden Atmosphäre noch stärker reduziert werden können.

Diese Aufgabe wird durch die kennzeichnenden Merkmale des Patentanspruchs 1 gelöst. Vorteilhafte Ausführungsarten und Weiterbildungen des erfindungsgemäßen Verfahrens sind in den Unteransprüchen angegeben.

Die an der oder in unmittelbarer Nähe der zu behandelnden Metallisierungsstruktur vorherrschende Temperatur wird im folgenden Wafertemperatur genannt. Während des Behandlungsschritts mit dem Wasserstoff-/Wasser-Gemisch wird durch die Wärmezufuhr eine Wafertemperatur eingestellt, die im folgenden Prozeßtemperatur genannt wird.

In welchem Ausmaß die Wolframoxidausdampfung über den gattungsbildenden Stand der Technick hinaus verringert werden kann, hängt von der Vornahme weiterer Maßnahmen wie der Einstellung bestimmter Wafertemperaturen, Anstiegs- und Abfallzeiten (Rampzeiten) der Wafertemperatur sowie dem Wasserstoff-/Wasser-Konzentrationsverhältnis ab.

Es ist beispielsweise zuzätzlich von Vorteil, wenn während eines ersten Abschnitts einer Behandlung mit der wasserstoffhaltigen Substanz vor dem Behandlungsschritt mit dem Wasserstoff-/Wasser-Gemisch die Wärmezufuhr so eingestellt wird, daß die Wafer-temperatur von einer ersten Temperatur T₁ auf eine zweite Temperatur T₂ ("bestimmte Temperatur") erhöht wird, wobei vorzugsweise die erste Temperatur in einem Bereich zwischen Raumtemperatur und 200°C liegt und weiterhin vorzugsweise die zweite Temperatur in einem Bereich zwischen 700°C und 900°C liegt. Dabei kann vorgesehen sein, daß die Wafertemperatur anfänglich noch konstant auf der ersten Temperatur gehalten wird und anschließend kontinuierlich oder schrittweise auf die zweite Temperatur erhöht wird.

Die erfindungsgemäße Verfahrensmaßnahme besteht darin, während eines Abschnitts des Behandlungsschritts mit dem Wasserstoff-/Wasser-Gemisch die Wärmezufuhr so einzustellen, daß die Wafertemperatur von einer bestimmten Temperatur auf eine Prozeßtemperatur erhöht wird. Dabei kann vorgesehen sein, daß die Wafertemperatur anfänglich noch konstant auf der bestimmten Temperatur gehalten wird und anschließend kontinuierlich oder schrittweise auf die Prozeßtemperatur erhöht wird. Die bestimmte Temperatur kann dabei durch die weiter oben genannte zweite Temperatur gebildet sein, die in einem Bereich zwischen 700°C und 900°C liegt, und die Prozeßtemperatur kann durch eine dritte Temperatur T₃ gebildet sein, die in einem Bereich zwischen 900°C und 1100°C liegt.

Es hat sich unabhängig von der in dem vorangehenden Abschnitt beschriebenen Verfahrensmaßnahme als vorteilhaft erwiesen, die Wafertemperatur während des Behandlungsschritts mit dem Wasserstoff-/Wässer-Gemisch auf eine Prozeßtemperatur in einem Bereich zwischen 900°C und 1100°C einzustellen.

Ferner kann während eines zweiten Abschnitts der Behandlung mit der wasserstoffhaltigen Substanz nach dem Behandlungsschritt mit dem Wasserstoff-/Wasser-Gemisch die Wärmezufuhr so eingestellt werden, daß die Wafertemperatur von einer Prozeßtemperatur auf eine niedrigere Temperatur kontinuierlich oder schrittweise absenkt wird. Die Prozeßtemperatur kann dabei durch die weiter oben genannte dritte Temperatur T₃ gebildet sein, die in einem Bereich zwischen 900°C und 1100°C liegt, und die niedrigere Temperatur kann eine Temperatur sein, die unterhalb der weiter oben genannten zweiten Temperatur T₂ und somit in einem Bereich 300°C-600°C liegt.

Vor und gegebenenfalls nach der Beaufschlagung mit der wasserstoffhaltigen Substanz kann noch eine Behandlung mit einem Inertgas, insbesondere reinem Stickstoff durchgeführt werden.

Es ist zu gewährleisten, dass während des Behandlungsschritts mit dem Wasserstoff/Wasser-Gemisch zumindest ein Zustand in der Nähe eines Reaktionsgleichgewichts zwischen einer Oxidationsreaktion und einer Reduktionsreaktion eingenommen wird. Vorzugsweise wird jedoch der Wasseranteil in dem zugeführten Wasserstoff-Wasser-Gemisch und die Prozesstemperatur derart gewählt, dass in dem Reaktionsgleichungspaar

W + 3H₂O ⇄ WO₃ + 3H₂.

die Reaktionsgleichung

WO₃ + 3H₂ → W + 3H₂O

eine größere, insbesondere viel größere Reaktionsgeschwindigkeit aufweist.

Dabei hat es sich ferner als vorteilhaft gezeigt, wenn der Wasseranteil in dem Wasserstoff-Wasser-Gemisch für die Dauer des Behandlungsabschnitts unterhalb von 20% liegt und gleichzeitig eine Prozeßtemperatur derart gewählt wird, daß die oben genannten Bedingungen bezüglich der chemischen Reaktionen eingehalten werden.

Das erfindungsgemäße Verfahren kann prinzipiell in jeder Temperanlage durchgeführt werden, in der eine Reaktionskammer enthalten ist, welche eine Einlassöffnung und eine Auslassöffnung aufweist, wobei in der Reaktionskammer Substrate, welche die Metallisierungsstrukturen enthalten, derart angeordnet werden können, dass Prozessgase von der Einlaßöffnung zu der Auslaßöffnung daran vorbeiströmen können.

Das Verfahren kann beispielsweise in einer lampengeheizten RTP-(Rapid Thermal Processing-) Anlage durchgeführt werden. Diese Anlage weist eine Reaktionskammer mit einer Einlassöffnung auf, in der die Prozessgase beispielsweise durch Massenflussregler gesteuert der Reaktionskammer zugeführt werden können. Die Prozessgase strömen an den Siliziumscheiben vorbei einer Auslassöffnung zu, durch die sie mittels eines Unterdrucks oder einer Pumpe aus der Reaktionskammer wieder abgesaugt werden können. Der Wafer wird durch Bestrahlung mit einer Hochleistungslampe erhitzt.

Das Verfahren kann jedoch ebenso in einer konventionellen Ofenanlage wie beispielsweise einem Vertikal- oder Horizontalrohrofen angewandt werden.

Besonders gute Ergebnisse werden erzielt, wenn alle vorstehend beschriebenen zusätzlichen Maßnahmen hinsichtlich der Wafertemperatur und des Temperatur-Rampings durchgeführt werden. Es ist jedoch auch möglich, auf einzelne dieser Maßnahmen zu verzichten, wenn die mit ihnen erzielbaren Verbesserungen den Aufwand ihrer Durchführung nicht mehr rechtfertigen.

Es zeigt sich, dass durch die neu entwickelte Prozessführung die Ausdampfung des Wolframoxids sehr stark reduziert wird und somit insbesondere in lampengeheizten RTP-Anlagen keine die Betriebsweise der Anlage beeinträchtigenden Ablagerungen auftreten, so daß die Prozessstabilität wesentlich gesteigert werden kann. Bei einer Durchführung der selektiven Oxidation in konventionellen Ofenanlagen werden durch das erfindungsgemäße Verfahren schädliche Ablagerungen von Wolframoxid auf dem Halbleiterwafer selbst und den auf ihm gebildeten Strukturen vermieden.

Im folgenden wird das erfindungsgemäße Verfahren und eine bevorzugte Ausführungsart anhand der Zeichnungsfiguren näher erläutert. Es zeigen: ,
- Fig. 1A-C: einzelne Verfahrensschritte einer eine Wolframschicht enthaltenden Gatestruktur nach dem Stand der Technik;
- Fig. 2: ein Diagramm zur Darstellung der Reaktionsmechanismen und -gleichgewichte;
- Fig. 3: eine bevorzugte Prozeßführung des erfindungsgemäßen Verfahrens.

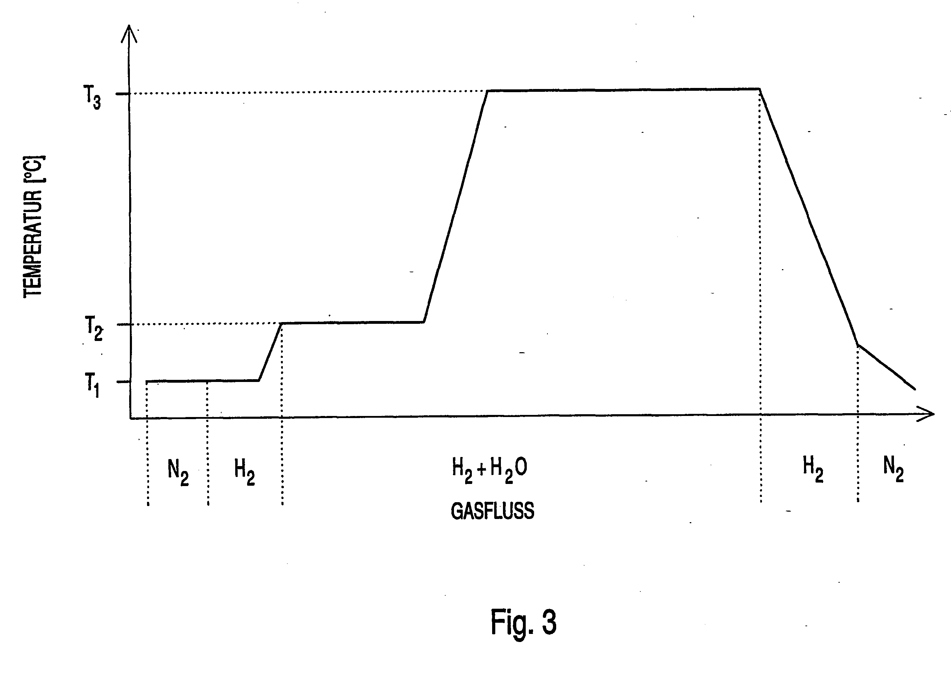

In der Fig.3 ist eine beispielhafte Prozeßführung dargestellt, bei welcher unmittelbar vor und nach der Zufuhr des. Wasser/Wasserstoff-Gasgemischs eine Behandlung mit reinem Wasserstoffgas (H₂) durchgeführt wird.

Die Auftragung der Wafertemperatur auf der Ordinate ist nicht linear.

zunächst wird bei einer sehr niedrigen ersten Temperatur T₁, beispielsweise 50°C (die tatsächliche Temperatur ist durch konventionelle Pyrometermessung nicht ermittelbar) Stickstoff durch die Reaktionskammer geleitet, um den Sauerstoff aus der Reaktionskammer zu entfernen. Die erste Temperatur T₁ kann im Bereich zwischen Raumtemperatur und 200°C liegen.

Daran schließt sich eine Behandlung mit reinem Wasserstoffgas an. Durch die Einlassöffnung der Reaktionskammer wird somit Wasserstoffgas bei zunächst gleichbleibender erster Temperatur T₁ zugeführt und im weiteren Verlauf der Wasserstoffbehandlung wird die Temperatur kontinuierlich in einer Rampe auf die zweite Temperatur T₂ von beispielsweise 800°C erhöht.

Dann wird eine Wasserstoff-/Wasser-Mischung der Reaktionskammer zugeführt, wobei die Durchflussregler so eingestellt werden können, dass in der Reaktionskammer eine Atmosphäre mit einem Wasseranteil von beispielsweise 14 Vol-% eingestellt wird. Die Prozesstemperatur wird zunächst noch konstant auf der zweiten Temperatur T₂ von 800°C gehalten, dann jedoch innerhalb einer zweiten Temperaturrampe kontinuierlich auf die dritte Temperatur T₃ von beispielsweise 1050°C erhöht. Bei dieser dritten Temperatur T₃ (Prozeßtemperatur) wird in der beschriebenen Weise die Behandlung mit dem Wasserstoff/Wasser-Gemisch durchgeführt, bei der auf den Seitenwänden der polykristallinen Siliziumschicht 2 und gegebenenfalls auf dem Siliziumsubstrat 10 (s. Fig. 1B) eine SiO₂-Schicht gebildet wird.

Daran schließt sich eine erneute Behandlung mit reinem Wasserstoffgas an, während der die Wafertemperatur kontinuierlich von der dritten Temperatur T₃ auf eine Temperatur unterhalb der zweiten Temperatur T₂ zurückgefahren wird. Nach dieser Behandlung wird die Reaktionskammer erneut von Stickstoff durchströmt, während dessen die Wafertemperatur auf eine Ausfahrtemperatur reduziert wird. Anstelle von Stickstoff kann auch ein anderes Inertgas verwendet werden.

Anstelle der Behandlung mit reinem.Wasserstoffgas unmittelbar vor und nach der Behandlung mit dem Wasserstoff/Wasser-Gemisch kann auch ein Wasserstoff/Stickstoff-Gemisch verwendet werden. Denkbar sind noch andere Inertgas-Gemische, in denen Wasserstoff enthalten ist.

Anstelle der dargestellten kontinuierlichen Temperaturrampen können auch diskontinuierliche schrittweise Änderungen der Temperatur vorgenommen werden.

Die Prozeßzeit der Behandlung mit dem Wasserstoff/Wasser-Gemisch beträgt typischerweise 30-60 Sekunden, während die Temperaturrampzeiten beispielsweise im Bereich von 10-50 °C/s liegen. Je nach der Wahl der anderen Prozeßparameter, insbesondere der Temperatur und des Wasseranteils, können sich aber auch andere Zeiten ergeben.

## Patentansprüche

1. Verfahren zur selektiven Oxidation einer Metallisierungsstruktur, insbesondere einer Gatestruktur, welche mindestens eine zu oxidierende, insbesondere polykristalline Siliziumschicht und mindestens eine nicht zu oxidierende Wolframschicht enthält, wobei
- die Metallisierungsstruktur in einem Behandlungsschritt unter Wärmezufuhr mit einem Gemisch von Wasserstoff und Wasser beaufschlagt wird,
- die Metallisierungsstruktur vor und gegebenenfalls nach dem Behandlungsschritt mit einer nichtwäßrigen wasserstoffhaltigen Substanz, insbesondere reinem Wasserstoff oder einem Wasserstoff/Inertgas-Gemisch beaufschlagt wird, wobei Während des Behandlungsschritts die Temperatur der Metallisierungsstruktur (Wafertemperatur) bei einer bestimmten Temperatur (T₂) im Bereich 700°C - 800°C liegt,
**dadurch gekennzeichnet, dass**
- während eines Abschnitts des Behandlungsschritts die Wärmezufuhr so eingestellt wird, daß die Temperatur der Metallisierungsstruktur (Wafertemperatur) von einer bestimmten Temperatur (T₂) auf eine Prozeßtemperatur (T₃) erhöht wird, und
- während mindestens eines Abschnitts des Behandlungsschritts die Wärmezufuhr so eingestellt wird, daß die Temperatur an der oder in unmittelbarer Nähe der Metallisierungsstruktur, insbesondere die Prozeßtemperatur (T₃), im Bereich 900°C-1100 °C liegt.

2. Verfahren nach Anspruch 1,
**dadurch gekennzeichnet, dass**
- während eines ersten Abschnitts der Behandlung mit der wasserstoffhaltigen Substanz vor dem Behandlungsschritt die Wärmezufuhr so eingestellt wird, daß die Temperatur der Metallisierungsstruktur (Wafertemperatur) von einer ersten Temperatur (T₁) auf die bestimmte Temperatur (T₂) erhöht wird.

3. Verfahren nach Anspruch 1 oder 2,
**dadurch gekennzeichnet, dass**
- während eines zweiten Abschnitts der Behandlung mit der wasserstoffhaltigen Substanz nach dem Behandlungsschritt die Wärmezufuhr so eingestellt wird, daß die Temperatur der Metallisierungsstruktur kontinuierlich von der Prozeßtemperatur (T₃) auf eine niedrigere Temperatur, insbesondere die erste Temperatur (T₁) abgesenkt wird.

4. Verfahren nach einem der vorhergehenden Ansprüche,
**dadurch gekennzeichnet, dass**
- der Wasseranteil in dem Gemisch für die Dauer des Behandlungsschritts unterhalb von 20% liegt.

5. Verfahren nach einem der Ansprüche 2 bis 4,
**dadurch gekennzeichnet, dass**
- die erste Temperatur (T₁) höher als Raumtemperatur und niedriger als 200°C ist.

6. Verfahren nach einem der vorhergehenden Ansprüche,
**dadurch gekennzeichnet, dass**
- die Metallisierungsstruktur vor und gegebenenfalls nach der Beaufschlagung mit der wasserstoffhaltigen Substanz mit einem Inertgas behandelt wird.

7. Verfahren nach einem der vorhergehenden Ansprüche,
**dadurch gekennzeichnet, dass**
- während dem Behandlungsschritt der Wasseranteil und die Temperatur derart gewählt werden, dass in dem Reaktionsgleichungspaar
W + 3H₂O ⇄ WO₃ + 3H₂
die Reaktionsgleichung
WO₃ + 3H₂ → W + 3H₂O
die größere Reaktionsgeschwindigkeit aufweist.

8. Verfahren nach einem der vorhergehenden Ansprüche,
**dadurch gekennzeichnet, dass**
- es in einer Reaktionskammer durchgeführt wird, welche eine Einlassöffnung und eine Auslassöffnung aufweist, und
- in der Reaktionskammer Substrate, welche die Metallisierungsstrukturen enthalten, derart angeordnet sind, dass Prozessgase von der Einlaßöffnung zu der Auslassöffnung daran vorbeiströmen können.

9. Verfahren nach einem der vorhergehenden Ansprüche,
**dadurch gekennzeichnet, dass**
- das Verfahren in einer Tempervorrichtung, insbesondere in einer lampengeheizten Kurzzeittemper-(RTP- oder RTA-) Vorrichtung durchgeführt wird.

10. Verfahren zur Herstellung einer Metallisierungsstruktur, insbesondere einer Gatestruktur eines MOS-Bauelements, mit mindestens einer, insbesondere polykristallinen Siliziumschicht und mindestens einer Wolframschicht, wobei im Verlaufe der Herstellung ein selektives Oxidationsverfahren nach einem oder mehreren der vorhergehenden Ansprüche durchgeführt wird.

## Claims

1. Method for the selective oxidation of a metallization structure, in particular of a gate structure, which includes at least one silicon layer, which is to be oxidized and in particular is in polycrystalline form, and at least one tungsten layer, which is not to be oxidized, in which method
- the metallization structure is acted on by a mixture of hydrogen and water in a treatment step in which heat is supplied,
- the metallization structure is acted on by a nonaqueous hydrogen-containing substance, in particular pure hydrogen or a hydrogen/inert gas mixture, before and, if appropriate, after the treatment step, wherein during the treatment step, the temperature of the metallization structure (wafer temperature) lies at a specific temperature (T₂) in the range from 700°C - 800°C,
**characterized in that**
- during a section of the treatment step the supply of heat is set in such a way that the temperature of the metallization structure (wafer temperature) is increased from a defined temperature (T₂) to a process temperature (T₃),
- at least during one section of the treatment step, the supply of heat is set in such a way that the temperature at or in the immediate vicinity of the metallization structure, in particular the process temperature (T₃), is in the range from 900°C-1100°C.

2. Method according to Claim 1,
**characterized in that**
- during a first section of the treatment with the hydrogen-containing substance before the treatment step, the supply of heat is set in such a way that the temperature of the metallization structure (wafer temperature) is increased from a first temperature (T₁) to the defined temperature (T₂).

3. Method according to Claim 1 or 2
**Characterized in that**
- during a second section of the treatment with the hydrogen-containing substance after the treatment step, the supply of heat is set in such a way that the temperature of the metallization structure is reduced continuously from the process temperature, (T₃) to a lower temperature, in particular the first temperature (T₁) .

4. Method according to one of the preceding claims,
**characterized in that**
- the water content in the mixture is below 20% for the duration of the treatment step.

5. Method according to one of Claims 2 to 4, wherein
- the first temperature (T₁) is higher than room temperature and lower than 200°C.

6. Method according to one of the preceding claims,
**characterized in that**
- the metallization structure is treated with an inert gas before and, if appropriate, after it has been acted on by the hydrogen-containing substance.

7. Method according to one of the preceding claims,
**characterized in that**
- during the treatment step the water content and the temperature are selected in such a manner that in the pair of reaction equations
W - 3H₂O ⇄ WO₃ + 3H₂
the reaction equation
WO₃ + 3H₂ → W + 3H₂O
has the greater reaction rate.

8. Method according to one of the preceding claims,
**characterized in that**
- it is carried out in a reaction chamber which has an inlet opening and an outlet opening, and
- substrates which include the metallization structures are arranged in the reaction chamber in such a manner that process gases can flow past the substrates from the inlet opening to the outlet opening.

9. Method according to one of the preceding claims,
**characterized in that**
- the method is carried out in a conditioning device, in particular in a lamp-heated rapid thermal processing or rapid thermal annealing (RTP or RTA) device.

10. Method for fabricating a metallization structure, in particular a gate structure of a MOS component, having at least one silicon layer, in particular a polycrystalline silicon layer, and at least one tungsten layer, a selective oxidation method according to one or more of the preceding claims being carried out during the fabrication.

## Revendications

1. Procédé d'oxydation sélective d'une structure de métallisation, notamment d'une structure de grille, qui contient au moins une couche de silicium à oxyder, notamment polycristalline et au moins une couche de tungstène qui n'est pas à oxyder, dans lequel
- on alimente la structure de métallisation, dans un stade de traitement avec apport de chaleur, en un mélange d'hydrogène et d'eau,
- on alimente la structure de métallisation avant et, le cas échéant, après le stade de traitement en une substance non aqueuse contenant de l'hydrogène, notamment en hydrogène pur, la température de la structure de métallisation (température de tranche) étant, pendant le stade de traitement à une température (T₂) déterminée, comprise entre 700°C et 800°C,
**caractérisé en ce que**
- pendant une partie du stade de traitement, on règle l'apport de chaleur de façon à ce que la température de la structure de métallisation (température de tranche) s'élève d'une température (T₂) déterminée à une température (T₃) de processus, et
- pendant au moins une partie du stade de traitement, on règle l'apport de chaleur de façon à ce que la température sur la structure de métallisation ou en sa proximité immédiate, notamment la température (T₃) de processus, soit comprise entre 900°C et 1100°C.

2. Procédé suivant la revendication 1,
**caractérisé en ce que**
- pendant une première partie du traitement par la substance contenant de l'hydrogène, avant le stade de traitement, on règle l'apport de chaleur de façon à ce que la température de la structure de métallisation (température de tranche) s'élève d'une première température (T₁) à la température (T₂) déterminée.

3. Procédé suivant la revendication 1 ou 2,
**caractérisé en ce que**
pendant une deuxième partie du traitement par la substance contenant de l'hydrogène, après le stade de traitement, on règle l'apport de chaleur de façon à ce que la température de la structure de métallisation s'abaisse continuellement de la température (T₃) de processus à une température plus basse, notamment à la première température (T₁) .

4. Procédé suivant l'une des revendications précédentes,
**caractérisé en ce que**,
- la proportion d'eau dans le mélange pendant la durée du stade de traitement est inférieure à 20 %.

5. Procédé suivant l'une des revendications 1 à 4,
**caractérisé en ce que**,
- la première température (T₁) est plus haute que la température ambiante et plus basse que 200°C.

6. Procédé suivant l'une des revendications précédentes,
**caractérisé en ce que**,
- on traite la structure de métallisation avant et, le cas échéant, après l'alimentation en la substance contenant de l'oxygène par un gaz inerte.

7. Procédé suivant l'une des revendications précédentes,
**caractérisé en ce que**,
- on choisit pendant le stade de traitement la proportion en eau et la température de façon à ce que dans la paire d'équations de réaction
W + 3H₂O ⇄ WO₃ + 3H₂
L'équation de réaction
WO₃ + 3H₂ → W + 3H₂O.
ait la vitesse de réaction la plus grande.

8. Procédé suivant l'une des revendications précédentes,
**caractérisé en ce que**,
- il s'effectue dans une chambre de réaction qui a une ouverture d'entrée et une ouverture de sortie et,
- on dispose dans la chambre de réaction des substrats qui contiennent la structure de métallisation de façon à ce que des gaz de processus puissent passer devant en allant de l'ouverture d'entrée à l'ouverture de sortie.

9. Procédé suivant l'une des revendications précédentes,
**caractérisé en ce que**,
- on effectue le procédé dans un dispositif de mise en température, notamment dans un dispositif de mise en température de courte durée à chauffage par lampe (dispositif RTP ou RTA).

10. Procédé de production d'une structure de métallisation, notamment d'une structure de grille d'un composant MOS, ayant au moins une couche de silicium, notamment polycristallin, et au moins une couche de tungstène, dans lequel on effectue, au cours de la production, un procédé d'oxydation sélective suivant l'une ou plusieurs des revendications précédentes.
